# EUROPÄISCHE PATENTSCHRIFT

(11) **EP 2 178 669 B1**
(45) Veröffentlichungstag und Bekanntmachung des Hinweises auf die Patenterteilung: **16.07.2014**
(21) Anmeldenummer: 08784195.3
(22) Anmeldetag: 10.06.2008
(51) Int. Cl.: B23K 1/018, B23K 3/02, B23K 26/14, H05K 13/04

(54) **VERFAHREN UND VORRICHTUNG ZUR ENTFERNUNG VON LOTMATERIALDEPOTS VON EINEM SUBSTRAT**
METHOD AND DEVICE FOR REMOVING SOLDER MATERIAL DEPOSITS FROM A SUBSTRATE
PROCÉDÉ ET DISPOSITIF D'ÉLIMINATION DE DÉPÔTS DE MATÉRIAU DE BRASURE D'UN SUBSTRAT

(30) Priorität: 13.07.2007 DE 102007033074
(43) Veröffentlichungstag der Anmeldung: 28.04.2010
(73) Patentinhaber: Pac Tech - Packaging Technologies GmbH, 14641 Nauen (DE)
(72) Erfinder: AZDASHT, Ghassem, 13591 Berlin (DE)
(74) Vertreter: von den Steinen, Axel
(86) Internationale Anmeldenummer: PCT/DE2008/000971
(87) Internationale Veröffentlichungsnummer: WO 2009/010029

(56) Entgegenhaltungen:
- WO-A-02/28582
- WO-A-98/57774
- US-A- 4 187 973
- US-A1- 2005 087 588

## Beschreibung

Die vorliegende Erfindung betrifft ein Verfahren zur Entfernung von Lotmaterialdepots von einem Substrat nach dem Oberbegriff des Anspruchs 1 sowie eine Vorrichtung und ein Substrat zur Durchführung des Verfahrens nach dem Oberbegriff des Anspruchs 5.

Bei den bekannten Belotungsverfahren, bei denen die Belotung von Kontaktsubstraten mit einem so genannten "ball-grid-array" erfolgt, werden Lotmaterialdepots von einer Transferschablone aus einem Lotmaterialreservoir aufgenommen und zur Belotung des Kontaktsubstrats in eine Überdeckungslage mit dem Kontaktsubstrat verbracht. Zur Erzeugung des "ball-grid-array" auf der Transferschablone ist dieses mit einem entsprechenden Lochmuster versehen und wird zur Entnahme der Lotmaterialdepots aus dem Lotmaterialreservoir rückwärtig mit Vakuum beaufschlagt. Hierdurch werden die Lotmaterialdepots, die einen gegenüber den Löchern des Lochmusters zumindest geringfügig größeren Durchmesser aufweisen, in den Löchern des Lochmusters gehalten.

Zur Belotung des Kontaktsubstrats wird die Transferschablone mit dem gegen die Anschlussfläche des Kontaktsubstrats anliegender Lotmaterialdepots gegen das Kontaktsubstrats gedrückt und die Lotmaterialdepots werden zur Erzielung eines zumindest partiellen Aufschmelzens derselben mit thermischer Energie beaufschlagt.

In Folge einer möglicherweise unzureichenden Flussmittelbeschichtung der Anschlussflächen des Kontaktsubstrats und/oder von Beschädigungen der benetzungshemmenden Oberfläche der Transferschablone kann es dazu kommen, dass sich nicht sämtliche Lotmaterialdepots von der Transferschablone ablösen. Zum einen werden hierdurch Belotungsfehlstellen auf dem Kontaktsubstrat ausgebildet, zum anderen ist es vor einem nachfolgenden Belotungsvorgang notwendig, haften gebliebene Lotmaterialdepots von der Transferschablone zu entfernen.

In Versuchen hat sich herausgestellt, dass ein Entfernen anhaftender Lotmaterialdepots vermittels eines mechanischen Ablösens, also beispielsweise eines Kratzens, zu einer Beschädigung der benetzungshemmenden Oberfläche der Transferschablone führt, wodurch zwar eine Entfernung des Lotmaterialdepots von der Transferschablone erfolgreich durchgeführt werden kann, die Gefahr eines erneuten Anhaftens eines Lotmaterialdepots bei einem nachfolgenden Belotungsvorgang jedoch potentiell erhöht wird.

Aus der WO 02/28582 A2 ist ein Verfahren und eine Vorrichtung zum Entfernen von Lotmaterialdepots bzw. Lötstellen von einem Substrat bekannt. Die Vorrichtung ist aus einer Aufnahmehülse mit einer Linseneinrichtung zum Aufbringen von Laserenergie auf das Lotmaterialdepot gebildet. Weiter umfasst die Vorrichtung eine Anschlusseinrichtung und eine Ausgabeeinrichtung, die jeweils quer zu einer Längsachse der Aufnahmehülse angeordnet sind und zur Beaufschlagung eines Hülsenlumens mit Druckluft in Art einer Venturi-Düse dienen. Die Aufnahmehülse ist so ausgebildet, dass das Lotmaterialdepot von einem Öffnungsrand der Aufnahmehülse im Wesentlichen direkt kontaktiert werden kann. Mittels der Vorrichtung erfolgt zunächst ein Aufschmelzen des Lotmaterialdepots durch Laserenergie und ein nachfolgendes Absaugen des flüssigen Lotmaterials vom Substrat durch Einblasen von Druckluft in die Aufnahmehülse.

Die US 4,187,973 beschreibt eine Vorrichtung zum Entlöten bzw. Absaugen von Lotmaterial. Eine Aufnahmehülse bzw. ein Aufnahmenhülsenverbund ist so ausgebildet, dass zwei Reihen von in einer Platine verlöteten Pins gleichzeitig entlötet werden können.

Eine weitere Vorrichtung zum gleichzeitigen Absaugen mehrerer Lotmaterialdepots offenbart die US 2005/0087588 A1, wobei die Vorrichtung hier ebenfalls einen regelmäßig angeordneten Aufnahmehülsenverbund aufweist, der zum gleichzeitigen Aufschmelzen und Absaugen von Kontakthöckern dient. Eine unmittelbare Kontaktierung eines Substrats ist nicht vorgesehen.

Aus der WO 98/57774 geht ein Verfahren bzw. eine Vorrichtung zur Ablösung von Kontakthöckern bzw. Lotmaterialdepots von einem Substrat hervor. Eine Aufnahmehülse ist mit einer Lasereinrichtung zum Aufschmelzen eines Lotmaterialdepots sowie mit einer Anschlussleitung zur Beaufschlagung eines Hülsenlumens mit einem Vakuum ausgestattet. Ein dementsprechend aufgeschmolzenes Lotmaterialdepot kann so von einem Substrat abgesaugt und einer Ausgabeeinrichtung, welche mit der Aufnahmehülse verbunden ist, zugeführt werden.

Der Erfindung liegt die Aufgabe zugrunde, ein Verfahren sowie eine Vorrichtung vorzuschlagen, die eine die Oberfläche der Transferschablone schonende Entfernung von anhaftenden Lotmaterialdepots ermöglicht.

Diese Aufgabe wird durch ein Verfahren mit den Merkmalen des Anspruchs 1 bzw. eine Vorrichtung mit den Merkmalen des Anspruchs 5 gelöst.

Bei dem erfindungsgemäßen Verfahren zur Entfernung von Lotmaterialdepots von einem Substrat mit den Merkmalen des Anspruchs 1 wird eine Aufnahmehülse mit einer Aufnahmeöffnung derart in Überdeckung mit einem auf dem Substrat angeordneten Lotmaterialdepot gebracht, dass ein Öffnungsrand der Aufnahmeöffnung im Wesentlichen abdichtend gegen das Substrat zur Anlage gebracht wird, das Lotmaterialdepot mit thermischer Energie beaufschlagt wird und ein durch die Aufnahmehülse definiertes Hülsenlumen quer zu einer Längsachse der Aufnahmehülse mit einer zu einer Ausgabeöffnung der Aufnahmehülse gerichteten Luftströmung beaufschlagt wird.

Die Beaufschlagung des Hülsenlumens mit der Querluftströtnung bewirkt zumindest während der abdichtenden Anlage der Aufnahmeöffnung gegen das Substrat einen temporären Unterdruck. Im Zusammenwirken mit der thermischen Beaufschlagung des Lotmaterialdepots, die ein zumindest partielles Aufschmelzen desselben bewirkt, wird das Lotmaterialdepot durch die Vakuumkraft von der Substratoberfläche abgelöst. Gleichzeitig sorgt die auf eine Ausgabeeinrichtung der Aufnahmehülsen gerichtete Querluftströmung für einen Abtransport des Lotmaterialdepots aus der Aufnahmehülse.

Das erfindungsgemäße Verfahren ermöglicht somit ein Ablösen oder Entfernen des Lotmaterialdepots von einer Substratoberfläche, ohne die direkte Einwirkung von mechanischen Werkzeugen auf das Lotmaterialdepot bzw. die Substratoberfläche. Der mögliche Berührungskontakt zwischen der Aufnahmehülse und der Substratoberfläche beschränkt sich auf einen anliegenden Öffnungsrand der Aufnahmeöffnung gegen die Substratoberfläche, um in der Aufnahmehülse aufgrund der quergerichteten Luftströmung einen Unterdruck ausbilden zu können. Je nach Größe des Volumenstroms der Querluftströmung kann es auch ausreichend sein, den Öffnungsrand der Aufnahmeöffnung unter Ausbildung eines minimalen Spalts, also unter Vermeidung eines unmittelbaren Berührungskontakts zur Substratoberfläche, gegen die Substratoberfläche zu verfahren.

Als besonders vorteilhaft hat es sich herausgestellt, die Beaufschlagung des Lotmaterialdepots mit thermischer Energie vermittels Laserenergie durchzuführen, da somit das Auftreten der gewünschten thermischen Effekte lokal auf das Lotmaterialdepot beschränkt werden kann, ohne dass beispielsweise strom- oder wärmeleitende Zuführungen notwendig wären.

Auf den Einsatz von Energie zuführenden Leitungen im Bereich der Aufnahmehülse kann sogar vollständig verzichtet werden, wenn die Laserenergie als Laserstrahlung in das Lotmaterialdepot eingebracht wird.

Als besonders vorteilhaft erweist es sich, wenn die Laserstrahlung vermittels einer das Hülsenlumen der Aufnahmehülse begrenzenden Linseneinrichtung fokussiert wird. Dabei kann die Linseneinrichtung gleichzeitig zur Ausbildung einer der Aufnahmeöffnung der Aufnahmehülse gegenüberliegenden, rückwärtigen Begrenzung des Hülsenlumens dienen.

Bei der erfindungsgemäßen Vorrichtung sowie dem Substrat mit den Merkmalen des Anspruchs 5 weist die Vorrichtung zur Ablösung von Lotmaterialdepots von einem Substrat eine Aufnahmehülse auf, die an einem Kontaktende mit einer Aufnahmeöffnung versehen ist und benachbart einer ein Hülsenlumen axial begrenzenden Begrenzungseinrichtung eine Ausgabeeinrichtung aufweist, eine der Ausgabeeinrichtung gegenüberliegend angeordnete Anschlusseinrichtung zur Beaufschlagung des Hülsenlumens mit Druckluft sowie eine Beheizungseinrichtung zur Beaufschlagung eines Lotmaterialdepots mit thermischer Energie auf.

In einer bevorzugten Ausführungsform weist die Beheizungseinrichtung eine Laserenergie-Emissionseinrichtung auf.

Wenn die Laserenergie-Emissionseinrichtung eine Linseneinrichtung zur Fokussierung eines Laserstrahlengangs auf einen durch einen Öffnungsrand begrenzten Öffnungsquerschnitt der Aufnahmeöffnung aufweist, kann die Laserenergie-Emissionseinrichtung in einem beliebigen Abstand vom Lotmaterialdepot bzw. vom Öffnungsquerschnitt der Aufnahmeöffnung angeordnet sein, so dass der Innenraum der Aufnahmehülse frei von Einrichtungen zur Zuführung der thermischen Energie zum Lotmaterial-depot ist.

Wenn darüber hinaus die Linseneinrichtung als Begrenzungseinrichtung zur axialen Begrenzung des Hülsenlumens ausgebildet ist, wird ein Aufbau der Vorrichtung mit einer möglichst geringen Anzahl von Teilen möglich.

Als besonders vorteilhaft erweist es sich, wenn die Ausgabeeinrichtung als eine die Druckluftströmung beschleunigende Beschleunigungseinrichtung ausgebildet ist, so dass die Erzeugung relativ großer Unterdruckkräfte im Hülsenlumen möglich wird.

In einer möglichen Ausführungsform der Vorrichtung ist die Ausgabeeinrichtung zur Beschleunigung der Druckluftströmung als Venturi-Düse ausgebildet.

Als besonders vorteilhaft für die Handhabung der Vorrichtung erweist es sich, wenn die Aufnahmehülse mit einer Positionierungseinrichtung zur veränderbaren Positionierung der Aufnahmehülse gegenüber dem Substrat versehen ist, so dass ein und dieselbe Aufnahmehülse zur Entfernung von Lotmaterialdepots an unterschiedlichen Obenflächenstellen des Substrats verwendbar ist.

Darüber hinaus ist es auch möglich, die Aufnahmehülse in einem Aufnahmehülsenverbund mit einer Mehrzahl von Aufnahmehülsen anzuordnen, um mehrere Lotmaterialdepots gleichzeitig von der Substratoberfläche entfernen zu können.

Eine Anordnung der Aufnahmehülse in einer Matrixanordnung eines Aufnahmenhülsenverbunds ermöglicht es, die Anordnung der Aufnahmehülsen entsprechend der Anordnung der Anschlussflächen auf der Substratoberfläche vorzusehen.

Nachfolgend wird eine bevorzugte Ausführungsform der Vorrichtung sowie des Substrats mit Erläuterung des vermittels der Vorrichtung durchführbaren Verfahrens unter Bezugnahme auf die Zeichnung näher erläutert.

Es zeigen:
- **Fig. 1**: eine mit einer Lotmaterialdepotanordnung bestückte Transferschablone;
- **Fig. 2**: die in **Fig. 1** dargestellte Transferschablone nach Übergabe der Lotmaterialdepotanordnung auf ein Kontaktsubstrat;
- **Fig. 3**: eine gegen die Transferschablone verfahrene Ablösevorrichtung zu Beginn eines Ablösevorgangs;
- **Fig. 4**: die gegen die Transferschablone verfahrene Ablösevorrichtung gegen Ende des Ablösevorgangs.

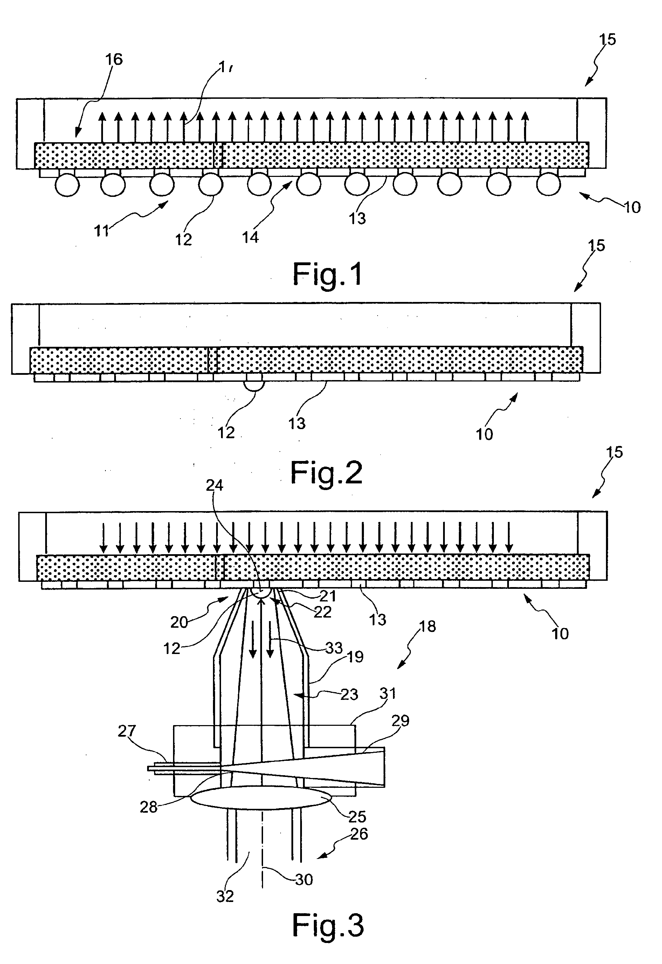

**Fig, 1** zeigt ein Substrat, das als Transferschablone 10 ausgebildet ist, die in einer in **Fig. 1** lediglich einachsig dargestellten Matrixanordnung eine Lotmaterialdepotanordnung 11 aus einzelnen Lotmaterialdepots 12 aufweist, die in Löchern 13 eines entsprechend der Matrixanordnung in der Transferschablone 10 ausgebildeten Lochmusters 14 angeordnet sind. Die Transferschablone 10 ist in einer Handhabungsvotrichtung 15 aufgenommen und stützt sich rückwärtig an einer porösen Metallplatte 16 ab.

Die Transferschablone 10 dient zur Entnahme von Lotmaterialdepots 12 aus einem hier nicht näher dargestellten Lotmaterialreservoir vermittels eines rückwärtig auf die Transferschablone 10 einwirkenden Unterdrucks 17. Wie in **Fig. 1** dargestellt, ermöglicht der Unterdruck 17 auch ein Halten der Lotmaterialdepots 12 in den Löchern 13 der Transferschablone, In dieser Konfiguration kann die Lotmaterialdepotanordnung 11 in eine Überdeckungslage mit einem hier nicht näher dargestellten Kontaktsubstrat überführt werden, in der sich die einzelnen Lotmaterialdepots 12 über zugeordneten Anschlussflächen des Kontaktsubstrats befinden. Zur Belotung der Kontaktflächen des Kontaktsubstrats mit den Lötmaterialdepots 12 wird die Transferschablone 10 gegen das Kontaktsubstrat abgesenkt, und unter gleichzeitiger Einwirkung von Druck und Temperatur auf die Lotmaterialdepots 12 erfolgt eine Übergabe der Lotmaterialdepots 12 auf die Kontaktflächen des Kontaktsubstrat bei gleichzeitigem Aufschmelzen der Lotmaterialdepots.

**Fig. 2** zeigt die Transferschablone 10 nach erfolgter Übergabe der Lotmaterialdepots 12, wobei beispielsweise in Folge einer Beschädigung der benetzungshemmend ausgeführten Oberfläche der Transferschablone 10 ein Lotmaterialdepot 12 nicht von der Transferschablone 10 abgelöst wurde.

**Fig. 3** zeigt die Transferschablone 10 mit einer Ablösevorrichtung 18, die zur Ablösung des an der Transferschablone 10 haften gebliebenen Lotmaterialdepots 12 verwendet wird.

Die Ablösevorrichtung 18 weist eine mundstückartig ausgebildete Aufnahmehülse 19 auf, deren in **Fig. 3** der Transferschablone 10 zugewandtes Kontaktende 20 eine von einem Öffnungsrand 21 begrenzte Aufnahmeöffnung 22 aufweist. Die Aufnahmehülse 19 weist ein Hülsenlumen 23 auf, das sich von einem Öffnungsquerschnitt 24 der Aufnahmeöffnung 22 bis zu einer am anderen Ende der Aufnahmehülse 19 angeordneten Linseneinrichtung 25 erstreckt. Die Linseneinrichtung 25 ist bei dem in **Fig. 3** dargestellten Ausführungsbeispiel der Ablösevorrichtung 18 zusammen mit der Aufnahmehülse 13 in einer Handhabungseinrichtung 26 aufgenommen.

Die Linseneinrichtung 25 ist bei dem in **Fig. 3** dargestellten Ausführungsbeispiel nicht nur Bestandteil einer nicht näher dargestellten Laser-Emissionseinrichtung, sondern dient gleichzeitig als Begrenzung des Hülsenlumens 23. Benachbart der Linseneinrichtung 25 befindet sich im Bereich des der Aufnahmeöffnung 22 gegenüberliegenden Endes der Aufnahmehülse 13 eine Druckluftanschlusseinrichtung 27, vermittels der das Hülsenlumen 23 gegenüberliegend einer Ausgabeeinrichtung 29 mit einer Querströmung 28 beaufschlagt wird. Die Ausgabeeinrichtung 29 kann beispielsweise als Venturi-Düse ausgebildet sein, um die über die Druckluft-Anschlusseinrichtung 27 im Hülsenlumen 23 induzierte, quer zu einer Längsachse 30 des Hülsenlumens 23 gerichtete Strömung 28 durch Expansion zu beschleunigen. Bei der in **Fig. 3** dargestellten Ausführungsform sind die Druckluft-Anschlusseinrichtung 27 und die Ausgabeeinrichtung 29 in einer gemeinsamen Strömungseinrichtung 31 ausgebildet, die modular mit der Aufnahmehülse 13 kombinierbar ist.

Zur Ablösung bzw. Entfernung des Lotmaterialdepots 12 von der Transferschablone 10, wird, wie in **Fig. 3** dargestellt, die Ablösevorrichtung 18 so gegen die Transferschablone 10 verfahren, dass sich der Öffnungsquerschnitt 24 der Aufnahmeöffnung 22 in einer Überdeckungslage mit dem Lotmaterialdepot 12 befindet. In **Fig. 3** ist hierzu der Öffnungsrand 21 der Aufnahmeöffnung 22 das Lotmaterialdepot 12 umschließend gegen die Oberfläche der Transferschablone 10 verfahren. In dieser Konfiguration erfolgt eine rückwärtige Beaufschlagung der Linseneinrichtung mit einem Laserstrahlengang 32, der durch die Linseneinrichtung 25 auf das Lotmaterialdepot 12 fokussiert wird und dieses zumindest partiell aufschmilzt. Durch das Aufschmelzen werden die Haltekräfte, die das Lotmaterialdepot 12 an der Oberfläche der Transferschablone 10 halten, reduziert. Über die Druckluft-Anschlusseinrichtung 27 wird das Hülsenlumen 23 mit einer Querströmung beaufschlagt, die zur Ausbildung eines Unterdrucks und entsprechender Unterdruckkräfte 33 im Hülsenlumen 23 sorgt.

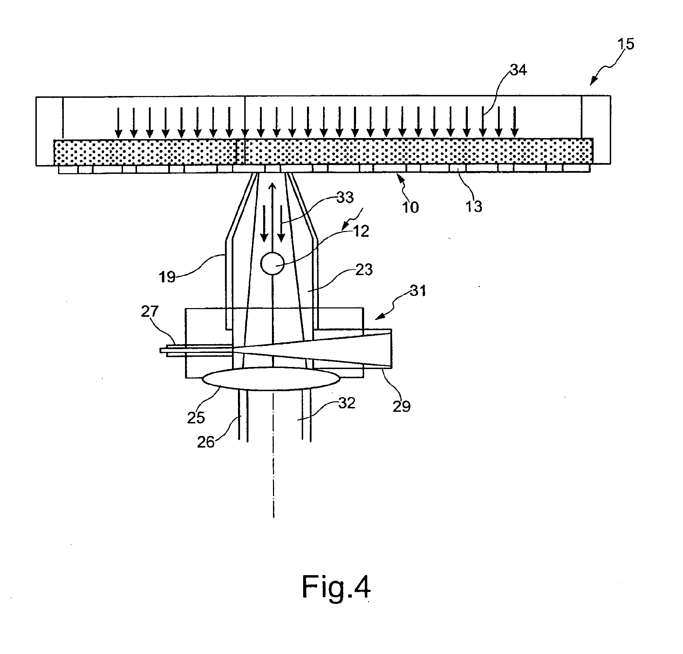

Wie in **Fig. 4** dargestellt, bewirken die Unterdruckkräfte 33, unterstützt durch die Verminderung der Haltekräfte in Folge der thermischen Beaufschlagung des Lotmaterialdepots 12, ein Ablösen des Lotmaterialdepots 12 von der Oberfläche der Transferschablone 10. Das Lotmaterialdepot 12 wird in Richtung auf die Querströmung 28 hin bewegt und schließlich von dieser mitgerissen und so durch die Ausgabeeinrichtung 29 nach außerhalb des Hülsenlumens 23 transportiert, wo eine Entsorgung des Lotmaterialdepots 12 stattfinden kann.

Um den vorstehend beschriebenen Ablösevorgang des Lotmaterialdepots 12 zu unterstützen, kann, wie in **Fig. 4** dargestellt, die Transferschablone 10 rückwärtig mit Druckluft 34 beaufschlagt werden.

## Patentansprüche

1. Verfahren zur Ablösung von anhaftenden Lotmaterialdepots (12) von einem Substrat (10), wobei das Lotmaterialdepot mit thermischer Energie beaufschlagt wird, und ein durch eine Aufnahmehülse (19) definiertes Hülsenlumen (23) quer zu einer Längsachse (30) der Aufnahmehülse mit einer zu einer Ausgabeeinrichtung (29) der Aufnahmehülse gerichteten Luftströmung (28) beaufschlagt wird, **dadurch gekennzeichnet, dass** die Aufnahmehülse (19) mit einer Aufnahmeöffnung (22) derart in Überdeckung mit einem auf dem Substrat angeordneten Lotmaterialdepot gebracht wird, dass ein Öffnungsrand (21) der Aufnahmeöffnung im Wesentlichen abdichtend gegen das Substrat zur Anlage gebracht wird, wobei der Öffnungsrand das Lotmaterialdepot umschließt.

2. Verfahren nach Anspruch 1,
**dadurch gekennzeichnet,**
**dass** die Beaufschlagung des Lotmaterialdepots (12) mit thermischer Energie vermittels Laserenergie erfolgt.

3. Verfahren nach Anspruch 2,
**dadurch gekennzeichnet,**
**dass** die Laserenergie als Laserstrahlung (32) auf das Lotmaterialdepot (12) aufgebracht wird.

4. Verfahren nach Anspruch 3,
**dadurch gekennzeichnet,**
**dass** die Laserstrahlung vermittels einer das Hülsenlumen (23) der Aufnahmehülse (19) begrenzenden Linseneinrichtung (25) fokussiert wird.

5. Vorrichtung zur Ablösung von Lotmaterialdepots (12) von einem Substrat sowie ein Substrat mit einem anhaftenden Lotmaterialdepot (12), wobei die Vorrichtung eine Aufnahmehülse (19) aufweist, die an einem Kontaktende (20) mit einer Aufnahmeöffnung (22) versehen ist und benachbart einer ein Hülsenlumen (23) axial begrenzenden Begrenzungseinrichtung eine Ausgabeeinrichtung (29) aufweist, wobei die Vorrichtung eine der Ausgabeeinrichtung gegenüberliegend angeordnete Anschlusseinrichtung (27) zur Beaufschlagung des Hülsenlumens mit Druckluft und eine Beheizungseinrichtung zur Beaufschlagung eines Lotmaterialdepots mit thermischer Energie aufweist,
**dadurch gekennzeichnet,**
**dass** ein Öffnungsrand (21) der Aufnahmeöffnung im Wesentlichen abdichtend gegen das Substrat zur Anlage bringbar ist, derart, dass der Öffnungsrand das Lotmaterialdepot umschließt, wobei das Substrat als Transferschablone (10) ausgebildet ist, wobei die Transferschablone ein Lochmuster (14) mit Löchern (13) zur Anordnung von Lotmaterialdepots aufweist.

6. Vorrichtung und Substrat nach Anspruch 5,
**dadurch gekennzeichnet,**
**dass** die Beheizungseinrichtung eine Laserenergie-Emissionseinrichtung aufweist.

7. Vorrichtung und Substrat nach Anspruch 6,
**dadurch gekennzeichnet,**
**dass** die Laserenergie-Emissionseinrichtung eine Linseneinrichtung (25) zur Fokussierung eines Laserstrahlengangs (32) auf einen durch einen Öffnungsrand (21) begrenzten Öffnungsquerschnitt (24) der Aufnahmeöffnung (22) aufweist.

8. Vorrichtung und Substrat nach Anspruch 7,
**dadurch gekennzeichnet,**
**dass** die Linseneinrichtung (25) als Begrenzungseinrichtung zur axialen Begrenzung des Hülsenlumens (23) ausgebildet ist.

9. Vorrichtung und Substrat nach einem der vorangehenden Ansprüche,
**dadurch gekennzeichnet,**
**dass** die Ausgabeeinrichtung (29) als eine die Druckluftströmung beschleunigende Beschleunigungseinrichtung ausgebildet ist.

10. Vorrichtung und Substrat nach Anspruch 9,
**dadurch gekennzeichnet,**
**dass** die Beschleunigungseinrichtung als Venturi-Düse ausgebildet ist.

11. Vorrichtung und Substrat nach einem der vorangehenden Ansprüche,
**dadurch gekennzeichnet,**
**dass** die Aufnahmehülse (19) mit einer Positionierungseinrichtung zur veränderbaren Positionierung der Aufnahmehülse gegenüber dem Substrat (10) versehen ist.

12. Vorrichtung und Substrat nach einem der vorangehenden Ansprüche,
**dadurch gekennzeichnet,**
**dass** die Aufnahmehülse (19) in einem Aufnahmehülsen-Verbund mit einer Mehrzahl von Aufnahmehülsen angeordnet ist.

13. Vorrichtung und Substrat nach Anspruch 12,
**dadurch gekennzeichnet,**
**dass** die Aufnahmehülsen in einer Matrixanordnung im Aufnahmehülsenverbund angeordnet sind.

## Claims

1. Method for separating adhering solder material deposits (12) from a substrate (10), wherein the solder material deposit is subjected to thermal energy and a sleeve lumen (23) that is defined by a receiving sleeve (19) is subjected to an air flow (28) transversely to a longitudinal axis (30) of the receiving sleeve, the air flow being directed to an output device (29) of the receiving sleeve,
**characterized in that**
the receiving sleeve (19) having a receiving opening (22) is positioned to overlap with a solder material deposit arranged on the substrate in such a manner that an opening edge (21) of the receiving opening is brought into abutment against the substrate in an essentially sealing manner, the opening edge enclosing the solder material deposit.

2. Method according to claim 1,
**characterized in that**
the application of thermal energy to the solder material deposit (12) is performed by using laser energy.

3. Method according to claim 2,
**characterized in that**
the laser energy is applied to the solder material deposit (12) in the form of laser radiation (32).

4. Method according to claim 3,
**characterized in that**
the laser radiation is focussed by means of a lens device (25) that limits the sleeve lumen (23) of the receiving sleeve (19).

5. Device for separating solder material deposits (12) from a substrate as well as a substrate comprising an adhering solder material deposit (12), the device exhibiting a receiving sleeve (19) that is provided with a receiving opening (22) at a contact end (20) thereof and that exhibits an output device (29) adjacent to a limiting device that limits a sleeve lumen (23) in an axial direction, the device comprising a connecting device (27) that is disposed opposite to the output device for subjecting the sleeve lumen to compressed air and a heating device for subjecting a solder material deposit to thermal energy,
**characterized in that**
an opening edge (21) of the receiving opening is brought into abutment against the substrate in an essentially sealing manner, such that the opening edge encloses the solder material deposit, wherein the substrate is designed as a transfer template (10), the transfer template exhibiting a hole pattern (14) with holes (13) for arranging solder material deposits therein.

6. Device and substrate according to claim 5,
**characterized in that**
the heating device exhibits a laser energy emission device.

7. Device and substrate according to claim 6,
**characterized in that**
the laser energy emission device exhibits a lens device (25) for focussing a laser beam path (32) on an opening cross-section (24) of the receiving opening (22) limited by an opening edge (21).

8. Device and substrate according to claim 7,
**characterized in that**
the lens device (25) is designed as a limiting device for limiting the sleeve lumen (23) in an axial direction.

9. Device and substrate according to any of the preceding claims, **characterized in that**
the output device (29) is designed as an acceleration device that accelerates the compressed air flow.

10. Device and substrate according to claim 9,
**characterized in that**
the acceleration device is designed as a Venturi nozzle.

11. Device and substrate according to any of the preceding claims,
**characterized in that**
the receiving sleeve (19) is provided with a positioning device for variable positioning of the receiving sleeve relative to the substrate (10).

12. Device and substrate according to any of the preceding claims,
**characterized in that**
the receiving sleeve (19) is arranged in a receiving sleeve assembly comprising a plurality of receiving sleeves.

13. Device and substrate according to claim 12,
**characterized in that**
the receiving sleeves are disposed in a matrix arrangement within the receiving sleeve assembly.

## Revendications

1. Procédé pour détacher des dépôts de matériau de brasage adhérents (12) d'un substrat (10), de l'énergie thermique étant appliquée au dépôt de matériau de brasage, et un flux d'air (28) orienté vers un dispositif de sortie (29) d'une douille de réception (19) étant appliqué transversalement par rapport à un axe longitudinal (30) de la douille de réception à un lumen de douille (23) défini par la douille de réception,
**caractérisé en ce que**
la douille de réception (19) ayant une ouverture de réception (22) est mise en coïncidence avec un dépôt de matériau de brasage disposé sur le substrat, de telle manière qu'un bord d'ouverture (21) de l'ouverture de réception soit mis en butée contre le substrat de manière essentiellement étanchante, le bord d'ouverture entourant le dépôt de matériau de brasage.

2. Procédé selon la revendication 1,
**caractérisé en ce que**
l'application d'énergie thermique au dépôt de matériau de brasage (12) s'effectue au moyen d'énergie laser.

3. Procédé selon la revendication 2,
**caractérisé en ce que**
l'énergie laser est appliquée au dépôt de matériau de brasage (12) sous forme de rayonnement laser (32).

4. Procédé selon la revendication 3,
**caractérisé en ce que**
le rayonnement laser est focalisé au moyen d'un dispositif de lentille (25) limitant le lumen de douille (23) de la douille de réception (19).

5. Dispositif pour détacher des dépôts de matériau de brasage (12) d'un substrat et un substrat ayant un dépôt de matériau de brasage adhérent (12), le dispositif comportant une douille de réception (19) qui est pourvue d'une ouverture de réception (22) à une extrémité de contact (20) et qui comporte un dispositif de sortie (29) adjacent à un dispositif de limitation limitant axialement un lumen de douille (23), le dispositif comportant un dispositif de connexion (27) disposé en face du dispositif de sortie pour appliquer de l'air comprimé au lumen de douille et un dispositif de chauffage pour appliquer de l'énergie thermique à un dépôt de matériau de brasage,
**caractérisés en ce qu'**
un bord d'ouverture (21) de l'ouverture de réception peut être mis en butée contre le substrat de manière essentiellement étanchante, de telle manière que le bord d'ouverture entoure le dépôt de matériau de brasage, le substrat étant formé comme gabarit de transfert (10), le gabarit de transfert ayant un motif de trous (14) avec des trous (13) pour la disposition de dépôts de matériau de brasage.

6. Dispositif et substrat selon la revendication 5,
**caractérisés en ce que**
le dispositif de chauffage comporte un dispositif d'émission d'énergie laser.

7. Dispositif et substrat selon la revendication 6,
**caractérisés en ce que**
le dispositif d'émission d'énergie laser comporte un dispositif de lentille (25) pour focaliser un trajet du faisceau laser (32) sur une coupe transversale d'ouverture (24) de l'ouverture de réception (22), ladite coupe transversale d'ouverture étant limitée par un bord d'ouverture (21).

8. Dispositif et substrat selon la revendication 7,
**caractérisés en ce que**
le dispositif de lentille (25) est formé comme dispositif de limitation pour limiter axialement le lumen de douille (23).

9. Dispositif et substrat selon l'une quelconque des revendications précédentes,
**caractérisés en ce que**
le dispositif de sortie (29) est formé comme dispositif d'accélération accélérant le flux d'air comprimé.

10. Dispositif et substrat selon la revendication 9,
**caractérisés en ce que**
le dispositif d'accélération est formé comme buse Venturi.

11. Dispositif et substrat selon l'une quelconque des revendications précédentes,
**caractérisés en ce que**
la douille de réception (19) est pourvue d'un dispositif de positionnement pour le positionnement changeable de la douille de réception par rapport au substrat (10).

12. Dispositif et substrat selon l'une quelconque des revendications précédentes,
**caractérisés en ce que**
la douille de réception (19) est disposée dans un ensemble de douilles de réception avec une pluralité de douilles de réception.

13. Dispositif et substrat selon la revendication 12,
**caractérisés en ce que**
les douilles de réception sont disposées dans un groupement matriciel dans l'ensemble de douilles de réception.
